Europäisches Patentamt

(19) European Patent Office

Office européen des brevets

(11) Publication number: **0 023 294**
**B1**

(12) EUROPEAN PATENT SPECIFICATION

(45) Date of publication of patent specification: **12.06.85**

(21) Application number: **80103965.2**

(22) Date of filing: **10.07.80**

(51) Int. Cl.⁴: **H 01 L 21/90, H 01 L 23/52**

(54) Method for repairing integrated circuits.

(30) Priority: **30.07.79 US 61951**

(43) Date of publication of application:
**04.02.81 Bulletin 81/05**

(45) Publication of the grant of the patent:
**12.06.85 Bulletin 85/24**

(84) Designated Contracting States:
**DE FR GB**

(56) References cited:
**GB-A-1 306 189**

**IBM TECHNICAL DISCLOSURE BULLETIN, vol.
17, no. 3, August 1974, page 948, New York, US
R.J. VON GUTFELD: "Interconnecting three-
dimensional arrays of circuits for memory and
logic applications"
IBM TECHNICAL DISCLOSURE BULLETIN, vol.
21, no. 6, November, 1978, pages 2591-2592,
New York, US W.K. SPRINGFIELD et al.:
"Personalizing a read-only memory with one
mask"**

(73) Proprietor: **International Business Machines
Corporation
Old Orchard Road
Armonk, N.Y. 10504 (US)**

(72) Inventor: **Dougherty Jr., William Edwin
34 LaGrange Ave.
Poughkeepsie, N.Y. 12603 (US)**

(74) Representative: **Barth, Carl Otto et al
IBM Deutschland GmbH Patentabteilung
Schönaicher Strasse 220
D-7030 Böblingen (DE)**

Courier Press, Leamington Spa, England.

## Description

This invention relates to the repair of opens and shorts in the metallurgy of multilevel devices.

Today's integrated circuits are characterized by miniaturization with large and complex numbers of interconnection patterns. Often, several levels of conductive interconnection patterns are required, each separated by an insulating layer having via holes for crossover connections between the conductor levels.

Fine line conductors present a particular problem in that discontinuities or shorts in conductor runs or shorts between conductor lines occur. They can be caused, for example, by the presence of pin-holes in resists employed for photolithographic delineation of the conductor patterns. This results in the rejection of circuits with attendant decrease in yield and increased cost. With the projected high densification of conductor patterns, the present fabrication processes are incapable of being economically employed for repairing the defective (e.g. shorted and/or open) conductors for purposes of reclaiming the devices.

A repair technique for eliminating discontinuities in metallization patterns is disclosed in IBM Technical Disclosure Bulletin, Vol. 20, No. 4, September 1977, page 1596. However, the method disclosed there is adapted to gas panels. Also, it does not provide a repair possibility for shorts being conductors.

Here, the invention as claimed intends to provide a remedy. Briefly spoken, the novel technique for repair of opens and shorts in integrated circuits consists of a sequence of steps which isolate the defective lines section(s) and bridge the ends of the perfect lines.

Basically, all shorted conductor lines are converted into opens by appropriate severing of the conductor lines below and above the shorted portions so as to isolate the shorted portion as a non-functional island. Next, the modified conductor pattern is overcoated with an appropriate dielectric layer (e.g. quartz, polyimide, silicon dioxide, silicon nitride, or combination thereof) in sufficient thickness to provide the desired insulation and/or passivation. For multilayered metallurgy, the dielectric layers can be applied in a portion normally half the thickness required by the specification anticipating insulation of superposed conductor patterns. After coating, via holes are formed in the dielectric layer to expose the terminal portions of the underlying conductor pattern at all points adjacent all opens. This can be followed by blanket coating the dielectric layer with the conductor metal, and delineating patch lines over all opens, including all shorted areas. Another dielectric layer can then be formed, e.g. by a blanket coating, over the conductive patch lines and the dielectric layer, which, when employed, can comprise the remaining half or portion of the specification thickness required for insulation of overlying conductive patterns.

One way of carrying out the invention is described below with reference to the appended drawings, in which:

Fig. 1 shows a portion of an integrated circuit with a defective metallization pattern;

Fig. 2 illustrates the circuit of Fig. 1 with opened defective lines;

Fig. 3 depicts the circuit of Fig. 1 after applying an insulating layer and forming holes through this layer;

Fig. 4 shows the same circuit after formation of conductive patch lines;

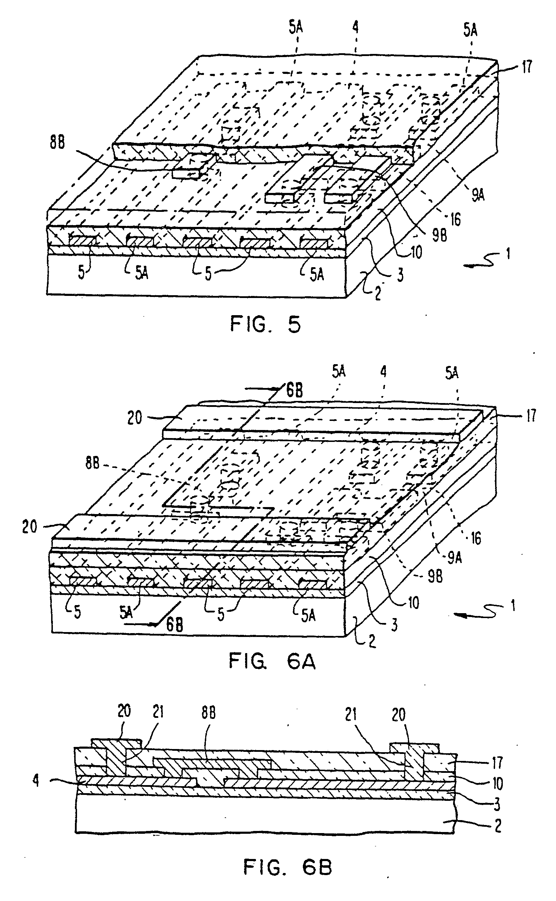

Fig. 5 illustrates the same circuit with an additional insulating layer;

Fig. 6A shows the finished product after applying the repair technique, and

Fig. 6B is a cross-section through the circuit of Fig. 6A.

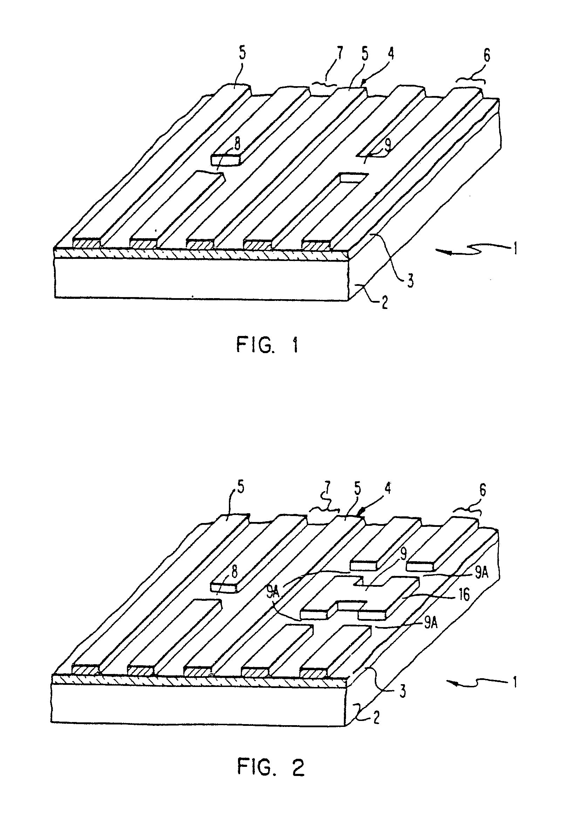

Fig. 1 shows a portion of an integrated circuit 1 which will normally have P- and N-type regions providing active and passive components of conventional integrated circuit such, for example, as described in U.S. Patents No. 3,539,876 and No. 4,076,575. The active and passive regions in substrate 2 have not been shown since they are not significant for this invention. Substrate 2 is covered with a passivating dielectric or insulating layer 3 which may be made of any of conventional materials such as quartz, polyimide, silicon dioxide, silicon nitride, or a composite of silicon nitride over silicon dioxide. The structures being described, unless otherwise noted, are conventional integrated circuit structures which may be fabricated by methods known in the art, e.g. U.S. Patent No. 3,539,876.

The dielectric or insulating layer 3 is a composite of a 100 nm thick bottom layer of silicon dioxide covered with a layer of silicon nitride 160 nm in thickness.

A first level metallization pattern 4 is formed over the surface of the dielectric layer 3. This metallization pattern which may be of a thickness of 0.85 microns, may also be of any conventional metal used in integrated circuit or electronic package fabrication. For example, the metallization can comprise aluminum and copper alloys thereof which can be applied by any technique such as those described in said U.S. Patent 3,539,876. The deposition may be, for example, vapor deposition or R.F. sputter or electro or electroless plated deposition. Normally, the metallization can be formed as a blanket coating which can be delineated into the desired pattern by photolithographic techniques.

Although the metallization can comprise complex and intricate patterns, however, for purposes of simplifying the description of this invention, the metallization pattern is shown as a series of conductor runs or lines 5. The widths 6 of the runs can be about 25 microns or less with a spacing 7 of about 3 microns between them.

The metallization pattern in configurations normally employed for integrated circuits and their package will include connections to various regions in substrate 2 by contacts passing through the dielectric layer 3. These have not been shown since it would not aid in the illustration of the present invention.

During the fabrication, opens or discontinuities 8 in the conductor lines 5 and shorts 9 between them occur. These defects are noted on inspection of the patterns, and their location can be located and translated to software for use with automated photolithographic units such as an E-beam unit.

In the next operation all shorts 9 are converted into opens 9A (Fig. 2) by any convenient manner, as by laser or E-beam burn out, or mechanically, or by conventional photolithographic techniques. The substrate is then coated with a blanket layer of a dielectric 10, in a thickness which can comprise a portion, preferably half of the specification thickness required for insulation in the formation of overlying conductor pattern of a multilayered conductor structure. This dielectric can be formed by any of the deposition techniques described in said U.S. Patent 3,539,876, for example, by chemical vapor deposition as well as spraying, cathode sputtering or R.F. sputtering methods. This layer 10 can be of conventional materials such as silicon nitride, aluminum oxide, polyimide or silicon dioxide, as well as composites thereof. Here, the layer comprises a 2—8 micron thick layer of R.F. sputter deposited silicon dioxide.

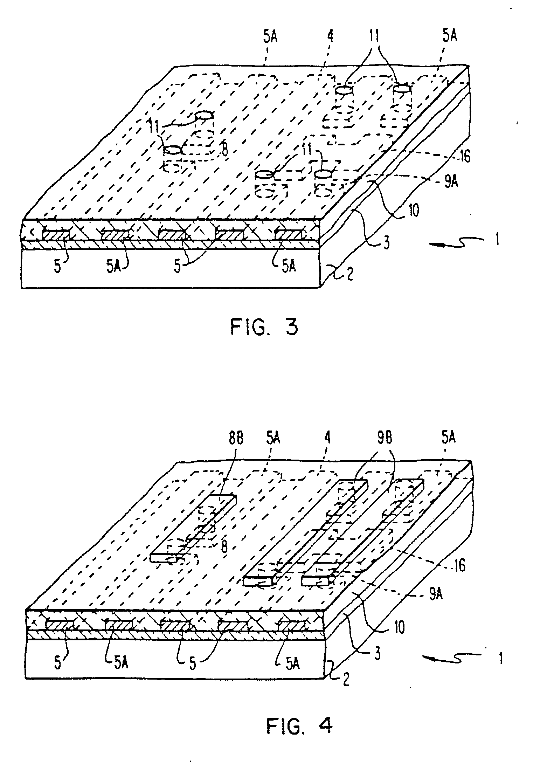

Next, as shown in Fig. 3, utilizing conventional photolithographic, or laser, or E-beam techniques, via holes 11 are formed, e.g. etched through dielectric layer 10 to expose portions at the terminal ends 5A of the desired basic conductor pattern 4 adjacent all opens 8 and 9A, inclusive of those resulting from the fabrication of the original conductor pattern and those formed about the short 9. After this step, the photoresist is removed, and the dielectric blanket coated with a conductive metal layer as noted above, in a minimum thickness sufficient for conductivity, e.g. about 1—2 microns. This conductive layer is then delineated by photolithographic techniques into conductive patch lines 8B bridging open 8, and into conductive patch lines 9B bridging opens 9A and spanning over the isolated shorted portion 16. One effective technique for delineating the patch lines is by E-beam lithography under computer control utilizing programmed location data observed and recorded for the original opens and shorts.

After formation of the patch lines 8B and 9B, a dielectric layer 17 is coated over the substrate to the thickness required for insulation. For example, where the dielectric layer 10 was applied at half the required specification thickness (e.g. 1—4 microns) for insulation, the thickness of the final dielectric layer 17 can be the remaining thickness (e.g. 1—4 microns) required for insulation. As will be understood, the dielectric layer 17 can be any of the conventional materials, applied by any conventional technique as discussed above. It may be noted that since the dielectric layers 10 and 17 were applied in two coats, there is an accompanying advantage in the minimization of the possibility of the occurrence of interplane pin-holes.

At this point, processing of the substrate can proceed in conventional manner, which can include the completion of multilayer metallization, which, for simplicity, has been illustrated as comprised of merely transverse conductor runs 20 interconnected to the underlying conductor pattern 4 (inclusive of patch lines 8B and 9B) through via connectors 21.

**Claims**

1. A method for repair of opens (8) and shorts (9) in a first metallization pattern (4) of a semiconductor device (1),
characterized by deleting portions of conductors (5) of said first pattern (4) on both sides of shorted sections (16) to form opens (9A),
coating said device (1) over said first pattern (4) with a first dielectric layer (10),
forming via holes (11) in said first dielectric layer (10) to the terminal ends of said conductors (5) of said first pattern (4) adjacent all opens (8, 9A), and
forming conductor patch lines (8B, 9B) on said first dielectric layer (10) over the opens (8, 9A) extending through said via holes (11) to the adjacent ends of said underlying conductors (5) of said first pattern (4) as part of said first metallization pattern (4).

2. The method of claim 1, further including:
coating a second dielectric layer (17) on said first dielectric layer (10) and said patch lines (8B, 9B),
forming via connectors (21) through said first and second dielectric layers (10, 17) to predetermined points of said first metallization pattern (4), and
forming a second metallization pattern (20) on said second dielectric layer (17) in interconnection with said first metallization pattern (4).

3. The method of claim 1, wherein said conductor patch lines (8B, 9B) are formed on said first dielectric layer (10) by blanket coating said semiconductor device (1) with a conductive layer and removing all portions of said conductive layer outside said conductor patch lines (8B, 9B).

4. The method of claim 2, wherein said first dielectric layer (10) comprises a fractional portion of a desired specification thickness, and said second dielectric layer (17) comprises the remainder of said desired specification thickness.

5. The method of claim 4 wherein said first dielectric layer (10) comprises about one-half said desired specification thickness.

**Patentansprüche**

1. Verfahren zur Reparatur von Leitungsunterbrechungen (8) und Kurzschlüssen (9) in einem ersten Metallisierungsmuster (4) einer Halbleitervorrichtung (1),
gekennzeichnet durch das Entfernen von Teilen der Leiter (5) des ersten Musters (4) auf beiden Seiten von kurzgeschlossenen Abschnitten (16) zur Bildung von Leitungsunterbrechungen (9A), das Beschichten der Vorrichtung (1) über dem ersten Muster (4) mit einer ersten dielektrischen Schicht (10),

das Herstellen von Kontaktierungsöffnungen (11) in der ersten dielektrischen Schicht (10) zu den den Leitungsunterbrechungen (8, 9A) benachbarten Enden der Leiter (5) des ersten Musters (4), und

das Herstellen von Korrekturleitungen (8B, 9B) auf der ersten dielektrischen Schicht (10) über den Leitungsunterbrechungen (8, 9A) durch die Kontaktierungsöffnungen (11) zu benachbarten Enden der darunterliegenden Leiter (5) des ersten Musters (4) als Teil des ersten Metallisierungsmusters (4).

2. Verfahren nach Anspruch 1, weiterhin umfassend:

das Aufbringen einer zweiten dielektrischen Schicht (17) auf die erste dielektrische Schicht (10) und den Korrekturleitungen (8B, 9B),

das Herstellen von Kontaktierungsverbindungen (21) durch die erste und zweite dielektrische Schicht (10, 17) zu bestimmten Punkten des ersten Metallisierungsmusters (4), und

das Herstellen eines zweiten Metallisierungsmusters (20) auf der zweiten dielektrischen Schicht (17) in Verbindung mit dem ersten Metallisierungsmuster (4).

3. Verfahren nach Anspruch 1, wobei die Korrekturleitungen (8B, 9B) auf der ersten dielektrischen Schicht (10) durch ganzflächige Beschichtung der Halbleitervorrichtung (1) mit einer leitenden Schicht vorgenommen wird und nachfolgende Entfernung aller Teile der leitenden Schicht außerhalb der Korrekturleitungen (8B, 9B).

4. Verfahren nach Anspruch 2, wobei die erste dielektrische Schicht (10) einen Bruchteil einer erwünschten spezifizierten Dicke und die zweite dielektrische Schicht (17) den Rest der erwünschten spezifizierten Dicke aufweist.

5. Verfahren nach Anspruch 3, wobei die erste dielektrische Schicht (10) ungefähr die Hälfte der erwünschten spezifizierten Dicke aufweist.

**Revendications**

1. Un procédé de réparation de coupures (8) et de court-circuits (9) dans un premier motif de métallisation (4) d'un dispositif semiconducteur (1), caractérisé en ce qu'il consiste à supprimer des parties de conducteurs (5) dudit premier motif (4) de part et d'autre des sections court-circuitées (16) pour former des coupures (9A), à revêtir ledit dispositif (1) sur ledit premier motif (4) d'une première couche diélectrique (10), à former des trous de traversée (11) dans ledit premier réseau diélectrique (10) jusqu'aux extrémités desdits conducteurs (5) dudit premier réseau (4) dans des zones adjacentes à toutes les coupures (8, 9A), et à former des lignes conductrices de réparation (8B, 9B) sur ladite première couche diélectrique (10) au-dessus des coupures (8, 9A), s'étendant au travers desdits trous de traversée (11) jusqu'aux extrémités adjacentes desdits conducteurs sousjacents (5) dudit premier motif (4) en faisant partie dudit premier motif de métallisation (4).

2. Le procédé de la revendication 1, consistant en outre à: déposer une seconde couche diélectrique (17) sur ladite première couche diélectrique (10) et lesdites lignes de réparation (8B, 9B), former des connecteurs de traversée (21) au travers desdites première et seconde couches diélectriques (10, 17) en des points prédéterminés dudit premier motif de métallisation (4), et former un second motif de métallisation (20) sur ladite seconde couche diélectrique (17) en interconnection avec ledit premier motif de métallisation (4).

3. Le procédé de la revendication 1, dans lequel lesdites lignes conductrices de réparation (8B, 9B) sont formées sur ladite première couche diélectrique (10) en déposant sur ledit dispositif semiconductuer (1) une couche conductrice et en enlevant toutes les parties de ladite couche conductrice à l'extérieur desdites lignes conductrices de réparation (8B, 9B).

4. Le procédé de la revendication 2, dans lequel ladite première couche diélectrique (10) a une épaisseur correspondant à une fraction d'une épaisseur spécifiée désirée, et ladite seconde couche diélectrique (17) comprend le reste de ladite epaisseur spécifiée désirée.

5. Le procédé de la revendication 4, dans lequel ladite première couche diélectrique (10) a une épaisseur ègale environ à la moitié de ladite épaisseur spécifiée désirée.

FIG. 1

FIG. 2

FIG. 3

FIG. 4

FIG. 5

FIG. 6A

FIG. 6B